(19) Europäisches Patentamt

European Patent Office

Office européen des brevets

(11) Veröffentlichungsnummer: **0 234 550 B1**

# (12) EUROPÄISCHE PATENTSCHRIFT

(45) Veröffentlichungstag der Patentschrift: **27.05.92**

(21) Anmeldenummer: **87102564.9**

(22) Anmeldetag: **24.02.87**

(51) Int. Cl.⁵: **H05K 7/20**

(54) **Wärmetauscherelement.**

(30) Priorität: **27.02.86 DE 3606334**

(43) Veröffentlichungstag der Anmeldung:
**02.09.87 Patentblatt 87/36**

(45) Bekanntmachung des Hinweises auf die
Patenterteilung:
**27.05.92 Patentblatt 92/22**

(84) Benannte Vertragsstaaten:
**AT BE CH DE ES FR GB GR IT LI LU NL SE**

(56) Entgegenhaltungen:
**EP-A- 0 029 577**
**DE-A- 2 416 471**
**DE-A- 3 045 326**
**DE-U- 8 510 233**
**GB-A- 246 137**

(73) Patentinhaber: **Autz + Herrmann**
**Karl-Benz-Strasse 10-12**
**W-6900 Heidelberg 1(DE)**

(72) Erfinder: **Autz, Helmut**
**Bergstrasse 152**
**W-6900 Heidelberg(DE)**
Erfinder: **Reinhard, Heinrich**
**Hans-Pfitzner-Strasse 28**
**W-6905 Schriesheim(DE)**

(74) Vertreter: **Rüger, Rudolf, Dr.-Ing. et al**
**Webergasse 3 Postfach 348**
**W-7300 Esslingen/Neckar(DE)**

## Beschreibung

Die Erfindung betrifft ein Wärmetauscherelement, insbesondere für Wärmetauscher zur staubfreien Kühlung von Schaltschränken oder dergl., mit einer Anzahl in einem aus im wesentlichen plattenförmigen Einzelteilen zusammengesetzten blockförmigen Paket nebeneinander angeordneter erster und zweiter Kanäle, die durch wärmetauschende Trennwände voneinander getrennt sind und jeweils auf verschiedenen Paketseiten liegende Ein- und Auslaßöffnungen für durchströmendes wärmezu- und wärmeabführendes Medium aufweisen.

Um die in Schaltschränken von dort untergebrachten elektrischen und elektronischen Schalt-, Steuer- und Regeleinrichtungen erzeugte Verlustwärme abzuführen, ohne dabei eine Verschmutzung der empfindlichen Schaltelemente in Kauf nehmen zu müssen, ist es bekannt, an einer Schaltschrankwand oder -tür einen Wärmetauscher anzuordnen, der einerseits in einem durch den Schaltschrankinnenraum geführten, von einem Gebläse erzeugten Innenkreislauf liegt und der andererseits von durch Gebläse geförderter Außenluft durchströmt ist, die als Kühlmedium verwendet wird und deren Förderung ebenfalls durch Gebläse erfolgt. Solche Wärmetauscher weisen ein an dem Schaltschrank abgedichtet zu befestigendes Gehäuse auf, in dem die den Innenkreislauf und der Außenluft zugeordneten Gebläse angeordnet sind und das ein eigentliches Wärmetauscherelement enthält, in dem die Wärmeübergabe von der in dem geschlossenen Innenkreislauf geführten erwärmten Luft auf die als Kühlmedium dienende Außenluft erfolgt. Bei einem aus der DE-PS 29 47 687 bekannten Wärmetauscher besteht das Wärmetauscherelement aus zu einem endseitig durch eine ebene Platte abgeschlossenen blockförmigen Paket zusammengefügten gleichen Blechplatten mit hochgebogenen seitlichen Rändern und einem an einer Stirnseite hochgebogenen Rand, wobei das Plattenpaket derart angeordnet ist, daß die Ebenen der Platten rechwinklig zur Wand des Schaltschrankes verlaufen. Zwischen den Trennwände bildenden Platten sind erste und zweite Kanäle ausgebildet, die jeweils auf verschiedenen Paketseiten liegende Ein- und Auslaßöffnungen für die die wärmezuführende Luft des Innenkreislaufes und die die Wärme abführende Außenluft aufweisen.

Zur Ermöglichung einer wirksamen Reinigung des verschmutzten oder verklebten Wärmetauschers ist es aus der DE-PS 30 45 326 bekannt, dieses das Wärmetauscherelement bildende Plattenpaket in dem die Gebläse enthaltenden Gehäuse lösbar anzuordnen, so daß es zu Reinigungszwecken entnommen werden kann.

Der Zusammenbau eines solchen paketförmigen Wärmetauscherelementes aus den einzelnen vorgebogenen Blechteilen ist verhältnismäßig zeitaufwendig, insbesondere dann, wenn die Platten an ihren hochgebogenen seitlichen Rändern miteinander verklebt werden müssen, um die geforderte Luft- und Staubdichtheit zu erzielen. Das Verkleben setzt nämlich u.a. ein vorheriges Entfetten der Blechteile voraus.

Außerdem müssen die Platten mit eigenen Werkzeugen gebogen werden, was bedeutet, daß jede Änderung der Plattenabmessungen zusätzliche erhebliche Werkzeugkosten mit sich bringt. Praktisch kann deshalb innerhalb einer Größe in der Regel nur die Plattenzahl wirtschaftlich verändert werden. Schließlich erfordern die Platten mehrfache Stanz- und Biegevorgänge, die ebenfalls aufwendig sind.

Es gibt daneben auch Wärmetauscherelemente, deren wärmetauschende Trennwände zwischen den mit dem wärmezu- und dem wärmeabführenden Medium beaufschlagten Kanälen aus einem mäanderförmig gebogenen Blech bestehen (DE-PS 24 16 471). Die Herstellung eines solchen mäanderförmig gebogenen Bleches größerer Abmessungen ist aber noch schwieriger und aufwendiger als das Stanzen, Biegen und Zusammenbauen einzelner Blechteile mit seitlich aufgebogenem Randteil.

Aufgabe der Erfindung ist es deshalb, ein Wärmetauscherelement, insbesondere für einen Wärmetauscher zur staubfreien Kühlung von Schaltschränken etc. zu schaffen, das sich bei stabilem Aufbau und hoher Maßhaltigkeit durch einfache, kostengünstige Herstellungsmöglichkeit in den jeweils erforderlichen Abmessungen auszeichnet.

Zur Lösung dieser Aufgabe ist das eingangs genannte Wärmetauscherelement erfindungsgemäß dadurch gekennzeichnet, daß zwischen zwei die Ober- und die Unterseite des Paketes bildenden, eingeformte, durchgehende nuten- oder wellenförmige Vertiefungen aufweisenden flachen Profilen aufrecht stehende, die Trennwände bildende Lamellen angeordnet sind, die randseitig in zugeordnete Vertiefungen der beiden flachen Profile dicht eingefügt und in diesen gehaltert sind und daß wenigstens eines der flachen Profile Ein- und/oder Auslaßöffnungen der ersten oder der zweiten Kanäle bildende Durchbrechungen aufweist, deren zugeordnete Kanäle an wenigstens einer Stirnseite durch aufgesetzte Verschlußelemente verschlossen sind.

Die flachen Profile können gewalzte oder gepreßte Blechprofile oder Strangpreßprofile, insbesondere aus Aluminium, sein. Sie sind deshalb leicht herstellbar; sie können einfach ausgestanzt werden und erfordern keine zusätzlichen Be- oder Umformarbeiten. Die Lamellen können ebenfalls durch einfache Schneidvorgänge hergestellt werden, wobei auch von der Rechteckform abweichende Gestaltungen, bspw. rautenförmige Formen, möglich sind, wenn dies die Gestalt des Paketes erforderlich macht.

Der Zusammenbau des Paketes ist einfach, da die einzelnen Lamellen lediglich in die Vertiefungen der beiden die Ober- und die Unterseite bildenden flachen Profile eingeschoben und stirnseitig die Verschlußelemente aufgesetzt werden müssen. Dazu kann auf die Lamellen stirnseitig jeweils ebenfalls ein eingeformte, durchgehende nuten- oder wellenförmige Vertiefungen aufweisendes flaches Profil aufgesteckt werden, in dessen Vertiefungen die Lamellen eingreifen. Dieses stirnseitig aufgesteckte Profilteil besteht aus dem gleichen Material wie die die Ober- oder die Unterseite des Paketes bildenden flachen Profile. Zumindest eines der stirnseitig angeordneten flachen Profile kann Ein- und/oder Auslaßöffnungen der ersten oder der zweiten Kanäle bildende Durchbrechungen aufweisen, die gleich mit ausgestanzt werden.

Die Lamellen selbst können ebene Platten sein, die vorzugsweise aus Aluminiumblech zugeschnitten sind. Sie können aber auch eine ihre Oberfläche vergrößernde Profilierung aufweisen, um die Wärmeaustauschleistung zu erhöhen. Dazu können die Lamellen bspw. eine wellenförmige Querschnittsgestalt aufweisen.

In einer anderen Ausführungsform können die Lamellen auch doppelwandig mit zwei im Abstand gegenüberstehenden Wandteilen ausgebildet sein, wobei die beiden Wandteilen jeder Lamelle in benachbarte Vertiefungen der flachen Profile eingefügt sein können. Alternativ können die beiden Wandteile jeder Lamelle unter Ausbildung eines Profilrohres auch randseitig miteinander verbunden sein, was auch durch Walzen geschehen kann, wobei es dann vorteilhaft ist, wenn jedes so gebildete Profilrohr mit einem Längsbereich in eine entsprechend gestaltete Vertiefung der flachen Profile eingefügt ist. Zwischen den Wandteilen jeder Lamelle können die Oberfläche vergrößernde Querwände angeordnet sein, die mit den Wandteilen wärmeleitend verbunden sind, was eine weitere Erhöhung der Wärmetauscherleistung zu erzielen gestattet.

Die Lamellen können zwischen den Seitenwänden der nutenartigen Vertiefungen der flachen Profile, gegebenenfalls unter Zwischenlage von Dichtmaterial, seitlich verklemmt sein. Dadurch läßt sich eine absolute Luft- und Staubdichtigkeit erzielen, wobei der Zusammenhalt der einzelnen Teile so fest wird, daß das ganze Paket ohne weitere Maßnahmen eine ausreichende Stabilität erhält. Es ist aber auch möglich, die Anordnung derart zu treffen, daß gegenüberliegende flache Profile durch Zuganker gegeneinander verspannt sind, wobei sich dann unter Umständen das seitliche Verklemmen der nutenartigen Vertiefungen mit den Lamellen erübrigt.

Schließlich ist es für besondere Anforderungen auch denkbar, daß die Lamellen mit den flachen Profilen verklebt sind, wie auch die Möglichkeit besteht, daß die flachen Profile und/oder die Lamellen aus Kunststoff bestehen.

Wenn die beiden Wandteile jeder doppelwandigen Lamelle zu einem Profilrohr randseitig miteinander verbunden sind, was in einem eigenen Arbeitsgang durch Umfalten, Verlöten, Verschweißen oder in der Weise geschehen kann, daß die Profilrohre nahtlos gezogen sind, können diese Profilrohre schließlich von einem flüssigen Kühlmedium, insbesondere Wasser, durchströmt sein, was den Vorteil mit sich bringt, daß die Wärmetauscherleistung in besonderem Maße gesteigert werden kann.

In der Zeichnung sind Ausführungsbeispiele des Gegenstandes der Erfindung dargestellt. Es zeigen:

Fig. 1        ein Wärmetauscherelement gemäß der Erfindung, in schematischer, perspektivischer Darstellung,

Fig. 2        das Wärmetauscherelement nach Fig. 1, in teilweiser auseinandergezogenem Zustand und in perspektivischer Darstellung,

Fig. 3        die flachen Profile und die die Seitenwände bildenden Lamellen des Wärmetauscherelementes nach Fig. 1, im auseinandergenommenen Zustand, in einer Draufsicht,

Fig. 4 - 6    eine Einzelheit des Wärmetauscherelementes nach Fig. 2, in einer Schnittdarstellung entsprechend der Linie V-V der Fig. 2, im Ausschnitt, in einem anderen Maßstab und in einer Seitenansicht, in drei verschiedenen Ausführungsformen,

Fig. 7 - 9    verschiedene Ausführungsformen von Lamellen des Wärmetauscherelementes nach Fig. 1, jeweils in perspektivischer schematischer Teildarstellung,

Fig.10        ein Wärmetauscherelement gemäß der Erfindung, im Querschnitt, in einer Teildarstellung, im auseinandergenommenen Zustand und in einer Seitenansicht,

Fig.11        das obere Profile und eine Lamelle eines Wärmetauscherelementes gemäß der Erfindung, in einer weiteren abgewandelten Ausführungsform, in einer schematischen, perspektivischen Teildarstellung,

Fig.12     eine Lamelle des Wärmetauscherelementes nach Fig. 11, in einer perspektivischen Teildarstellung, unter Veranschaulichung eines Endbereiches der Lamelle,

Fig.13     ein Verschlußelement für das Wärmetauscherelement nach Fig. 11, in einer Seitenansicht,

Fig.14     das Verschlußelement nach Fig. 13, in einer Seitenansicht,

Fig.15     das Verschlußelement nach Fig. 13, geschnitten längs der Linie XV-XV der Fig. 13, in einer Seitenansicht, unter teilweiser Veranschaulichung der benachbarten Lamellen,

Fig. 16    die Anordnung nach Fig. 15, in einer Schnittdarstellung entsprechend der Linie XVI-XVI der Fig. 14, in einer Draufsicht,

Fig. 17 - 21  verschiedene Ausführungsformen von doppelwandigen Lamellen für ein Wärmetauscherelement gemäß der Erfindung, jeweils im Querschnitt, in einer Seitenansicht, und

Fig. 22    ein Wärmetauscherelement gemäß der Erfindung, in der Zuordnung zu zwei benachbarten Schaltschränken, in schematischer perspektivischer Darstellung und im Ausschnitt.

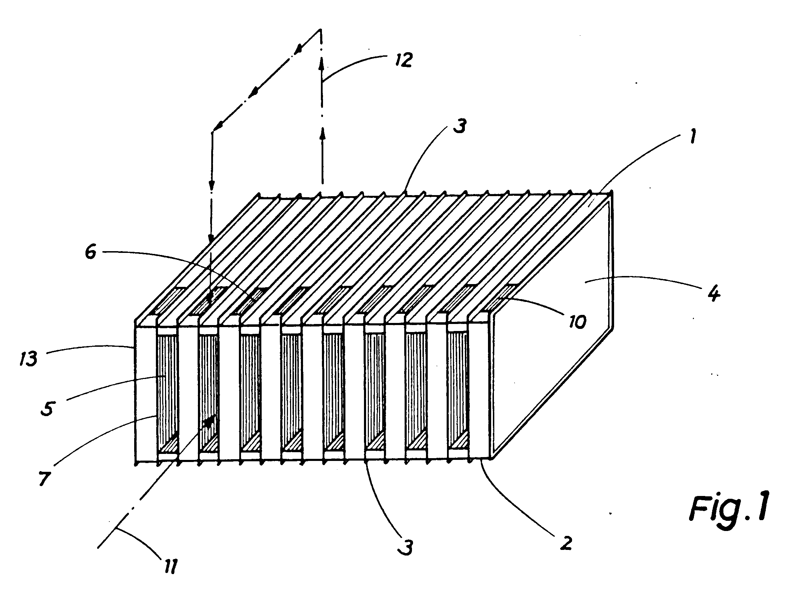

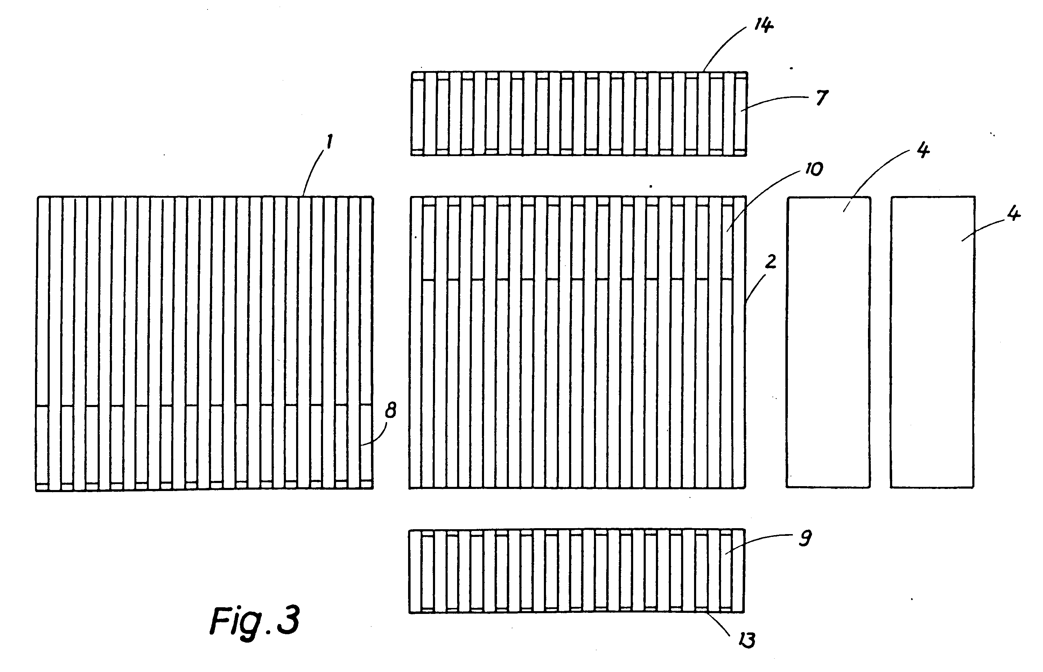

Das in den Fig. 1 - 3 dargestelle Wärmetauscherelement, das insbesondere für Wärmetauscher zur staubfreien Kühlung von Schaltschränken oder dergl. bestimmt ist, ist in Gestalt eines aus einer Anzahl plattenförmiger Einzelteile zusammengesetzten blockförmigen Paketes ausgebildet. Es weist im einzelnen zwei die Ober- und die Unterseite des Paketes bildende flache, im wesentlichen plattenförmige Profile 1,2 auf, die mit eingeformten, durchgehenden, nuten- oder wellenförmigen Vertiefungen 3 versehen sind, die in gleichen Abständen parallel zueinander verlaufend ausgebildet sind. Die flachen Profile 1,2 können gewalzte Blechprofile oder Strangpreßprofile, vorzugsweise aus Leichtmetall, sein, die in handelsüblichen Längen und Breiten hergestellt werden und aus denen die die Ober- und die Unterseite des Paketes bildenden Profilteile 1,2 in der entsprechenden Größe ausgestanzt sind.

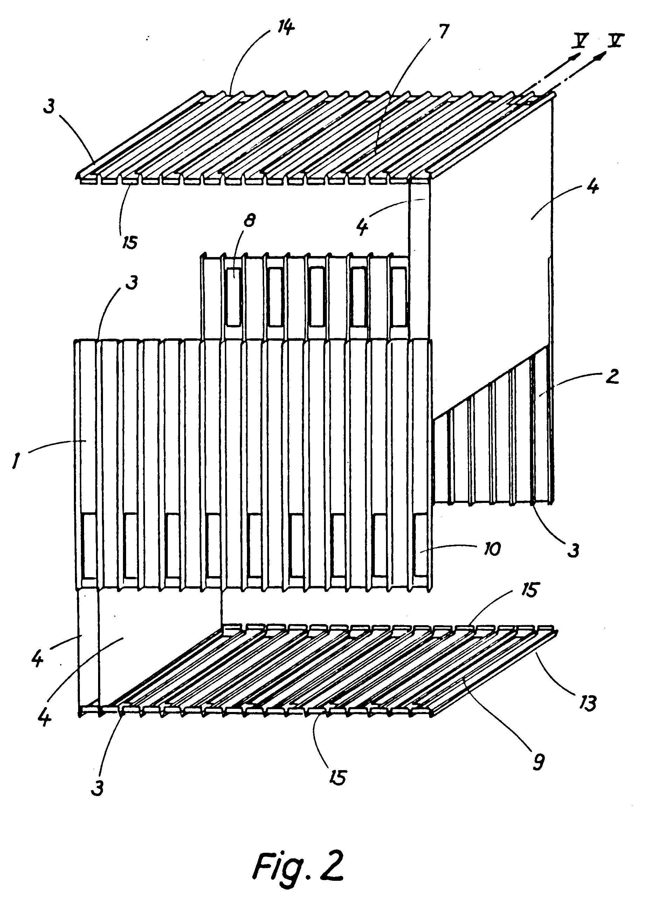

Zwischen den beiden flachen Profilen 1,2 sind plattenförmige, aufrechtstehende Lamellen 4 angeordnet, die parallel zueinander ausgerichtet in gleichen Abständen stehen und randseitig in zugeordnete Vertiefungen 3 der beiden flachen Profile 1,2 dicht eingefügt und in diesen gehaltert sind (vgl. Fig. 2). Die Lamellen 4, die vorzugsweise ebenfalls aus Leichtmetallblech ausgestanzt sind, bilden wärmetauschende Trennwände für nebeneinander angeordnete erste und zweite Kanäle 5,6, die auf verschiedenen Paketseiten liegende Ein- und/oder Auslaßöffnungen 7,8 bzw. 9,10 aufweisen. Bei dem dargestellten Ausführungsbeispiel ist, wie aus den Fig. 1 - 3 ersichtlich, die Anordnung derart getroffen, daß die ersten Kanäle 5 ihre Einlaßöffnungen 7 auf einer Stirnseite des Paketes haben, während ihre Auslaßöffnungen 8 in Gestalt von im wesentlichen rechteckigen Durchbrechungen in dem die Paketunterseite bildenden flachen Profil 2 in der Nähe der gegenüberliegenden Stirnseite des Paketes ausgebildet sind. Die Einlaßöffnungen 9 der zweiten Kanäle 6 liegen auf der den Einlaßöffnungen 7 der ersten Kanäle 5 gegenüberliegenden Stirnseite des Paketes; die zugehörigen Auslaßöffnungen 10 sind als rechteckige Durchbrechungen in dem die Paketoberseite bildenden flachen Profil 1 vorgesehen.

Die ersten Kanäle 5 sind bspw. von einem wärmezuführenden Medium, etwa der im geschlossenen Innenkreislauf eines Schaltschrankes geführten erwärmten Luft, durchströmt, während durch die zweiten Kanäle 6 wärmeabführendes Medium, bspw. von einem nicht dargestellten Gebläse geförderte Außenluft, strömt. Die beiden Mediumsströmungen sind in Fig. 1 durch Pfeile 11, 12 angedeutet.

Grundsätzlich ist naturgemäß auch eine andere Zuordnung des wärmezu- und des wärmeabführenden Mediums zu den ersten und zweiten Kanälen 5 bzw.6 möglich. Auch können die Ein- und Auslaßöffnungen 7 bis 10 in anderer Weise angeordnet sein, z.B. derart, daß die Ein- und Auslaßöffnungen 7,8 der ersten Kanäle 5 im Bereiche eines der beiden flachen Profile 1 oder 2 angeordnet sind, während die Ein- und Auslaßöffnungen 9,10 der zweiten Kanäle 6 stirnseitig vorgesehen sind.

Ein solches Wärmetauscherelement würde dazu geeignet sein, als Aufsatz auf einen Schaltschrank aufgesetzt zu werden.

Auf den beiden gegenüberliegenden Stirnseiten sind auf die Lamellen 4 zwei aus dem gleichen Material wie die flachen Profile 1,2 bestehende flache Profilteile 13, 14 mit ihren wellen- oder nutenförmigen Vertiefungen 3 aufgesetzt, so daß sich insgesamt ein parallelflächig begrenzter, im Querschnitt rechteckiger Körper ergibt, wie er in Fig. 1 perspektivisch veranschaulicht ist. Die stirnseitigen flachen Profilteile 13, 14 sind mit die Ein- bzw. Auslaßöffnungen 7,8 bildenden rechteckigen Durchbrechungen ausgestanzt, die den ersten bzw. zweiten Kanälen 5 bzw. 6 zugeordnet sind. Randseitig sind die stirnseitigen Profilteile 13,14 bei 15 in den Bereichen zwischen benachbarten Vertiefungen 3 etwa rechtwinklig hochgebogen, wobei im zusammengebauten Zustand die hochgebogenen Teile 15 die flachen Profile 1,2 übergreifen, so daß ein dichter Abschluß der Kanäle 5,6 gewährleistet ist, während gleichzeitig das ganze so gebildet Paket über eine hohe Stabilität verfügt.

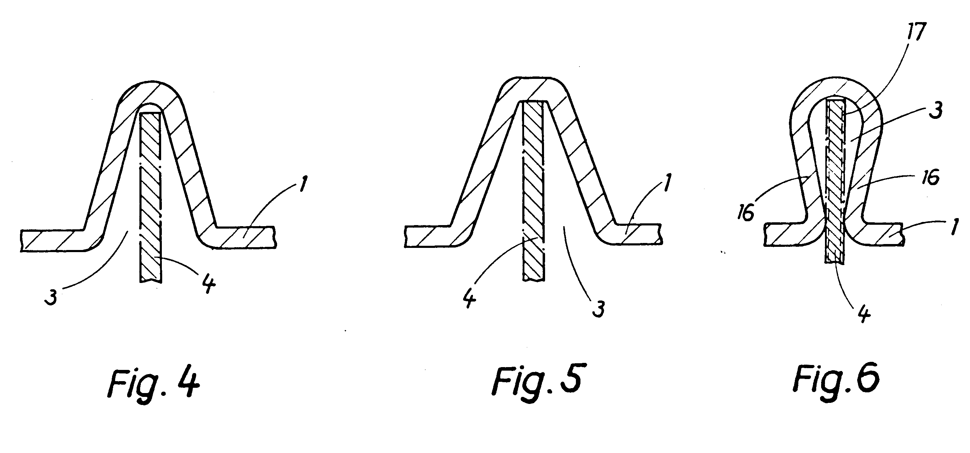

Die Vertiefungen 3 können entweder eine wellenförmige Querschnittsgestalt mit ausgerundetem Boden aufweisen, wie sie als Beispiel in Fig. 4 veranschaulicht ist, oder aber auch nutenartig gestaltet sein, wie dies in Fig. 5 schematisch dargestellt ist, wobei die Seitenflächen jeder nutenartigen Vertiefung 3 auch parallel zueinander ausgerichtet sein können. Häufig genügt die durch die abgebogenen Teile 15 der stirnseitigen Profilteile 13, 14 erzeugte Verklemmung zwischen den flachen Profilen 1,2 und den Lamellen 4, so daß keine weiteren Maßnahmen zur Erhöhung der Stabilität ergriffen werden müssen. Grundsätzlich ist es natürlich möglich, die flachen Profile 1,2 mit den Lamellen 4 im Bereiche der Vertiefungen zu verkleben.

Eine stabilere Verbindung zwischen den Lamellen 4 und den Profilen 1,2, ergibt sich, wenn in der aus Fig. 6 schematisch veranschaulichten Weise die die Vertiefungen 3 seitlich begrenzenden Wände 16 nach dem Einschieben der Lamellen 4 seitlich zusammengedrückt und mit den Lamellen 4 verklemmt werden, so daß eine reibschlüssige Verbindung entsteht. Dabei kann erforderlichenfalls jeder Lamelle 4 beidseitig ein Dichtmaterialstreifen 17 beigelegt werden, der eine absolut staub- und luftdichte Abdichtung der Kanäle 5,6 in diesen Bereichen gewährleistet.

Das vorstehend Gesagte gilt in gleichem Maße naturgemäß auch für die Vertiefungen 3 der stirnseitigen flachen Profilteile 13, 14 und deren Befestigung auf den stirnseitigen Randkanten der Lamellen 4.

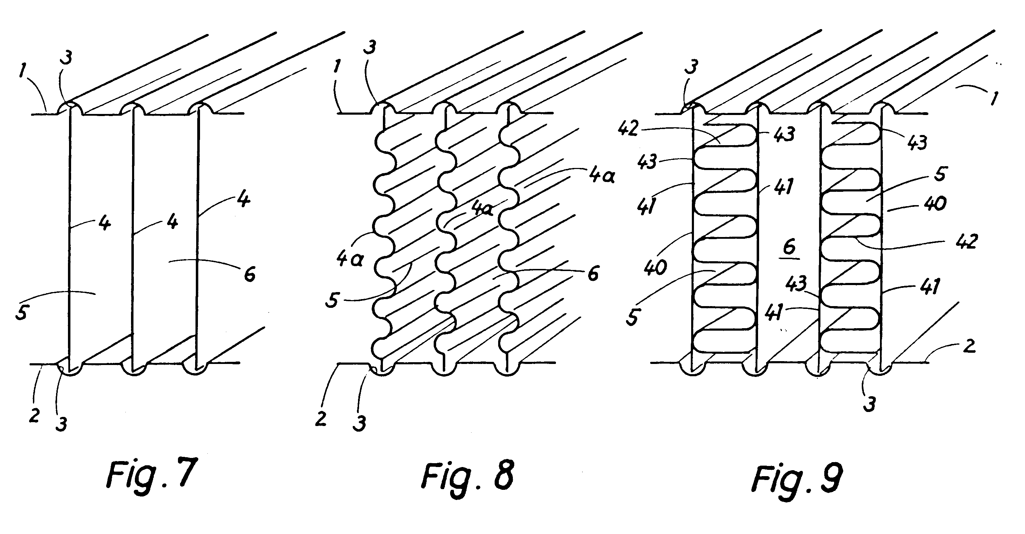

Bei der beschriebenen,in den Fig. 1 - 3 dargestellten Ausführungsform des Wärmetauscherelementes sind die Lamellen 4 durch ebene, glatte Leichtmetallblechplatten gebildet, die in parallelen Ebenen zueinander verlaufend angeordnet sind, so daß sich grundsätzlich die Anordnung nach Fig. 7 ergibt.

Um die wärmetauschende Oberfläche der von den Lamellen 4 gebildeten Trennwände zwischen benachbarten Kanälen 5,6 zu vergrößern, können die Lamellen 4 eine entsprechende Profilierung aufweisen. Dabei ergeben sich günstige Herstellungsverhältnisse, wenn die Lamellen 4a entsprechend Fig. 8 mit einer wellenförmigen Querschnittsgestalt ausgebildet sind; es sind aber auch andere Profilierungen denkbar.

Eine andere alternative Möglichkeit, die Wärmetauscherleistung zu erhöhen, besteht darin, daß die Lamellen, wie in Fig. 9 bei 40 beispielhaft veranschaulicht, doppelwandig mit zwei im Abstand gegenüberstehenden Wandteilen 41 ausgebildet sind, die parallel zueinander ausgerichtet sind. Zwischen den in benachbarten nutenartigen Vertiefungen 3 der flachen Profile 1,2 gehalterten Wandteilen 41 jeder Lamelle 40 sind die Oberfläche vergrößernde Querwände angeordnet, die durch einen mäanderförmig gebogenen Blechstreifen 42 gebildet sind, der mit den beiden Wandteilen 41 an den Berührungspunkten - bei 43 - wärmeleitend verbunden, bspw. verlötet, verschweißt oder verklebt ist. Auf diese Weise wird erreicht, daß von dem durchströmenden Medium an den Blechstreifen 42 abgegebene oder von diesem aufgenommene Wärme durch Wärmeleitung zu den damit verbundenen Wandteilen 41 transportiert wird, die auf ihren gegenüberliegenden Seiten jeweils von wärmeab- oder -zuführendem Medium angeströmt sind.

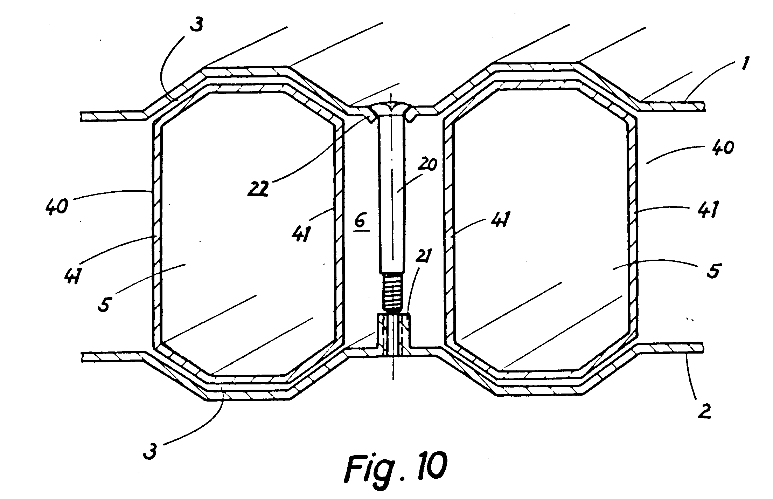

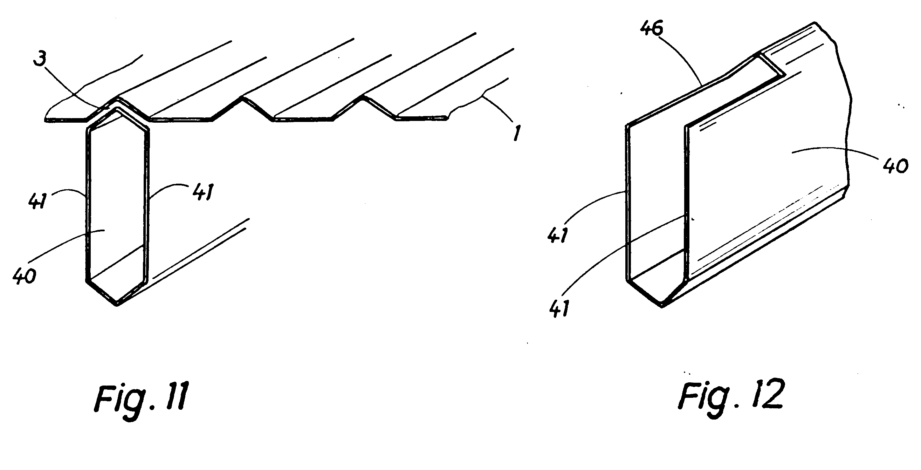

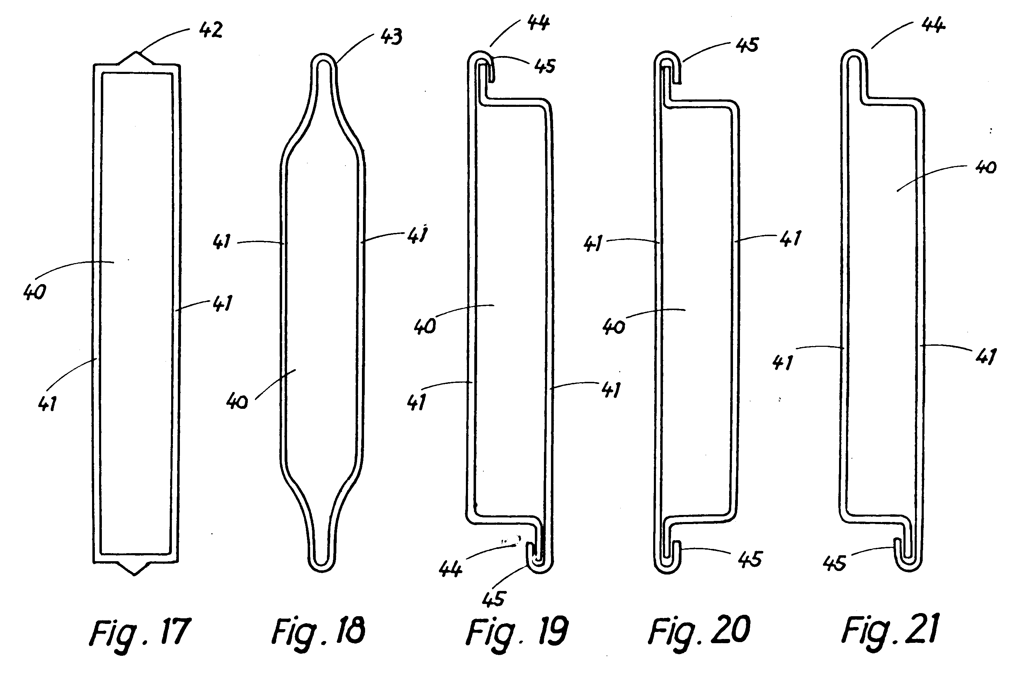

Die doppelwandigen Lamellen 40 können entsprechend der beispielhaften Ausführungsform nach den Fig. 10, 11 auch derart ausgebildet sein, daß die beiden Wandteile 41 unter Ausbildung eines geschlossenen Profilrohres randseitig miteinander verbunden sind. Die so gebildeten Profilrohre, die in der Regel eine längliche Querschnittsgestalt aufweisen, können entsprechend den Fig. 10, 11 nahtlos gezogene oder gepreßte Rohre sein, was den Vorteil mit sich bringt, daß die von diesen Profilrohren gebildeten Kanäle 5 auch mit einer Flüssigkeit, bspw. Wasser oder Öl, als wärmeabführendem Medium beaufschlagt werden können, da absolute Dichtheit gewährleistet ist. Dabei sind auch andere Querschnittsformen möglich, als die in den Fig. 10,11 dargestellten 6- oder 8-eckigen Profile. Beispiele dafür sind in den Fig. 17, 18 dargestellt, von denen Fig. 17 eine im Querschnitt rechteckige doppelwandige Lamelle 40 veranschaulicht, die in Gestalt eines geschlossenen Profilrohres ausgebildet ist und stirnseitig außen angeformte, im Querschnitt etwa dreieckförmige Rippen 42 trägt, mit denen sie in die entsprechend geformten Vertiefungen 3 der flachen Profile 1,2 eingreift. Bei der Ausführungsform nach Fig. 18 sind die ebenfalls in Gestalt eines geschlossenen Profilrohres ausgebildeten doppelwandigen Lamellen 40 stirnseitig mit einem Radius gebogen, wobei eine längliche rippartige Wulst 43 ausgebildet ist, die ähnlich der Rippe 42 dazu dient, die Lamellen 40 in den entsprechend gestalteten Vertiefungen 3 der Flachprofile 1,2 zu haltern.

Wenn die doppelwandigen Lamellen 40 nicht flüssigkeitsdichte Profilrohre zu sein brauchen, können sie auch als Walzprofile hergestellt werden, wozu die Ausführungsbeispiele nach den Fig. 19 - 21 Beispiele darstellen:

Bei der Ausführungsform nach Fig. 19 sind die beiden Wandteile 41 endseitig bei 44 an gegenüberliegenden Breitseiten durch einen umgebördelten Falz 45 miteinander verbunden, während bei der Ausführungsform nach Fig. 20 die beiden Falze 45 im Bereiche einer (der linken) Breitseite der Lamelle 40 angeordnet sind. Bei der Ausführungsform nach Fig. 21 schließlich ist lediglich ein solcher Falz 45 vorgesehen. Auf der gegenüberliegenden Stirnseite sind die beiden Wandteile 41 unter Ausbildung des zur Halterung in der zugeordneten Vertiefung 3 dienenden rippenartigen Wulstes 44 einstückig aneinander angeformt.

Wie bspw. Fig. 10 zeigt, können die Vertiefungen 3 der flachen Profile 1,2 auch der Umrißgestalt eines zugeordneten Längsbereiches der doppelwandigen Lamellen 40 angepaßt sein, ohne daß eine Rippe oder Wulst 42 bzw. 43,44 vorhanden ist. In diesem Falle ist es aber zweckmäßig, wenn die beiden flachen Profile 1,2 durch Zuganker 20, 21 miteinander verbunden und mit den als geschlossene Profilrohre ausgebildeten doppelwandigen Lamellen 40 abdichtend verklemmt sind. Die Zuganker 20, von denen in Fig. 10 lediglich einer dargestellt ist, verlaufen in den zwischen benachbarten Lamellen 40 angeordneten Kanälen 6. Sie bestehen jeweils aus einem in eine entsprechende Bohrung 22 des einen flachen Profils, bspw. 1, eingesetzten Gewindebolzen 20 und einer zugeordneten Schraubenmutter 21, die an dem anderen flachen Profil 2 verankert ist; ihre Zahl und Verteilung richtet sich nach den Abmessungen und zu erwartenden Beanspruchungen des Wärmetauscherelementes.

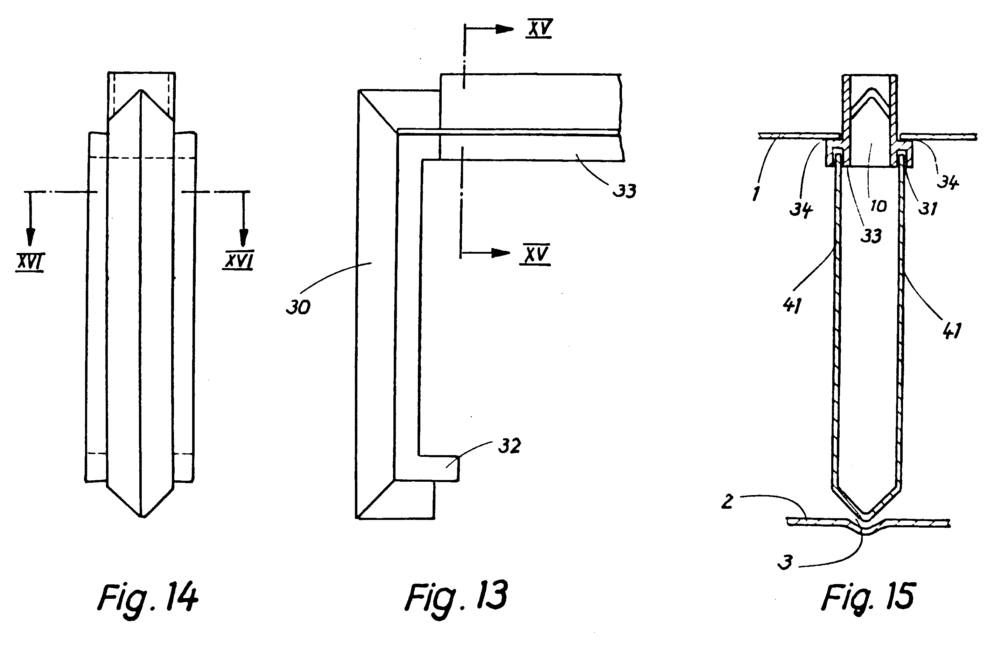

Um die von den doppelwandigen Lamellen 40 umschlossenen Kanäle 5 an einer Stirnseite des paketförmigen Wärmetauscherelementes zu verschließen und gleichzeitig die Ein- bzw. Auslaßöffnungen 10 in dem die Oberseite bildenden flachen Profil 1 herzustellen, finden eigene Kunststoffstopfen Verwendung, deren Aufbau insbesondere aus den Fig. 13 - 16 zu ersehen ist:

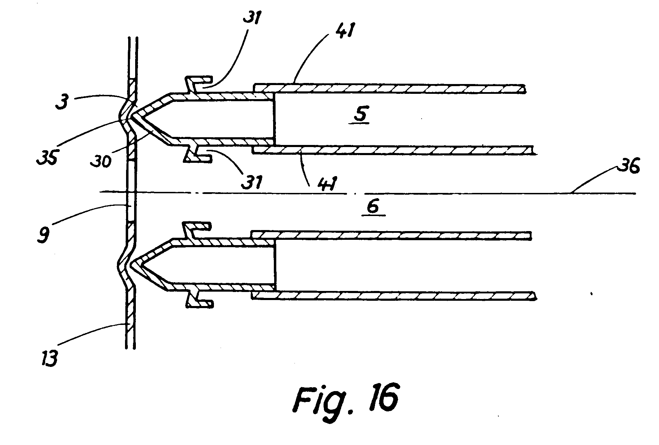

Die die doppelwandigen Lamellen 40 bildenden Profilrohre sind an ihrem einen Ende im Bereiche der Ein- bzw. Auslaßöffnungen 10 bei 46 in der aus Fig. 12 ersichtlichen Weise ausgeklinkt. Auf ihre stirnseitigen Seitenwände 41 ist jeweils ein etwa haubenförmiger Verschlußstopfen 30 aufgesteckt, der angeformte Nuten 31 aufweist, mit denen er die Wandteile 41 dichtend übergreift und dessen Länge der Höhe der Lamellen 40 entspricht. An seinem unteren Ende trägt jeder Verschlußstopfen 30 ein etwa rechtwinklig abstehendes Führungsteil 32, das der Innenumrißgestalt der doppelwandigen Lamelle angepaßt in diese eingeschoben wird. An dem gegenüberliegenden Ende ist der Stopfen 30 mit einem ebenfalls rechtwinklig abgehenden angeformten Fortsatz 33 versehen, der in Gestalt eines länglichen Rahmens ausgebildet ist, welcher auf seiner Außenseite der rechteckigen Gestalt der einer Ein- bzw. Auslaßöffnung 10 entsprechenden Durchbrechung des flachen Profiles 1 entspricht und auf seiner Innenseite die Ein- bzw. Auslaßöffnung 10 begrenzt. Wie aus Fig. 15 zu ersehen, ragt der Rahmen durch die Durchbrechung des flachen Profiles 1 nach außen, während gleichzeitig seitlich angeformte schulterartige Leisten 34,in denen die die Wandteile 41 übergreifenden Längsnuten 31 ausgebildet sind, sich von innen an das flache Profil 1 anlegen.

Um die Stopfen 30 sicher auf den Wandteilen 41 der doppelwandigen Lamellen 40 zu haltern, sind stirnseitig die Profilteile 13, 14 aufgesetzt, die mit ihren Vertiefungen 3 auf entsprechenden rippenartigen Anformungen 35 der Stopfen 30 aufliegen und durch bei 36 in Fig. 16 angedeutete Zuganker miteinander verspannt sein können.

Die flachen Profile 1,2 und die Lamellen 4, 4a und 40 werden ebenso wie die stirnseitigen Profilteile 13, 14 in der Regel aus Leichtmetall hergestellt werden. Es ist aber auch möglich, daß alle oder einzelne dieser Teile aus Kunststoffmaterial bestehen, was insbesondere bei großen Serien den Vorteil erheblicher Kostenersparnis mit sich bringt.

Unabhängig davon, ob die Teile als Blechstanzteile oder Kunststoffteile gefertigt sind, können sie ohne großen Aufwand sehr eng toleriert hergestellt werden, wobei die spezielle Art des Aufbaus des Wärmetauscherelementes gewährleistet, daß auch die Toleranzen der Außenabmessungen des paketartigen Wärmetauscherelementes sehr klein gehalten werden können, was wiederum den Einbau in ein Gehäuse etc. wesentlich erleichtert. Auch bietet sich eine Automatisierung sowohl der Herstellung der Einzelteile als auch des Zusammenbaus dieser Teile zu dem Wärmetauscherelement an, wobei auch von der Rechteckform abweichende Gestaltungen, bspw. im Querschnitt rauten- oder trapezförmige Formen, möglich sind. Ohne großen Aufwand können insbesondere auch Wärmetauscherelemente mit den jeweiligen Einsatzerfordernissen entsprechenden Außenabmessungen hergestellt werden. Dabei ist es auch möglich, ein Wärmetauscherelement aus mehreren nebeneinander angeordneten, gegebenenfalls miteinander verbundenen,Teil-Wärmetauscherelementen zusammenzusetzen.

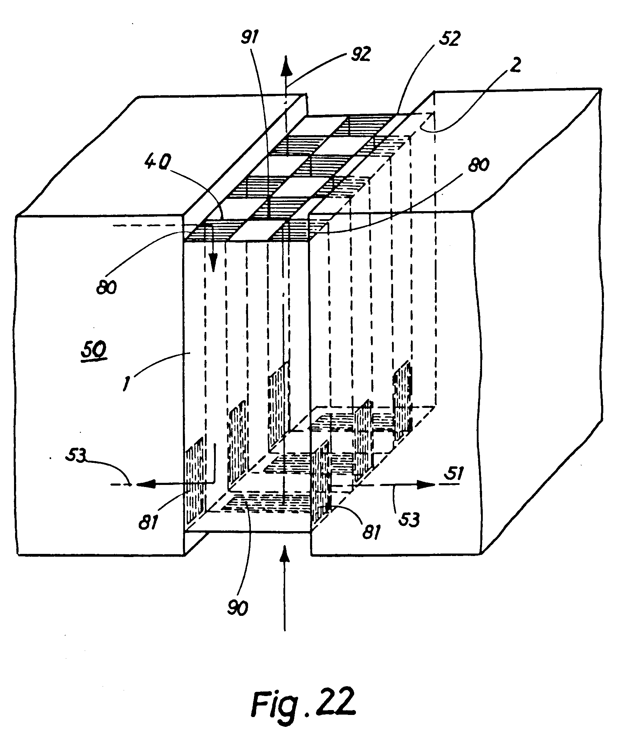

Da die Ein- und Auslaßöffnungen der Kanäle 5,6 ohne Mühe an beliebigen Seiten des Paketes angeordnet werden können, ergeben sich bei geringem Platzbedarf auch weitgehende Anpassungsmöglichkeiten an die Gegebenheiten der verschiedenartigen zu kühlenden Schaltschränke. In Fig. 22 ist als Beispiel für diese Vielseitigkeit schematisch veranschaulicht, wie ein solches mit 52 bezeichnetes Wärmetauscherelement, wie es grundsätzlich etwa in Fig. 1 veranschaulicht ist, zwischen zwei benachbarte Schaltschränke 50, 51 eingefügt werden kann, aus denen somit gleichzeitig Wärme durch ein einziges Wärmetauscherelement abgeführt wird. Die beiden durch nicht weiter dargestellte Gebläse erzeugten geschlossenen Innenluftkreisläufe sind durch Pfeile 53 angedeutet; sie verlaufen durch Ein- bzw. Auslaßöffnungen 80, 81 in den flachen Profilen 1,2. Die durch ebenfalls nicht veranschaulichte Gebläse geförderte Außenluft strömt durch stirnseitige Öffnungen 90, 91 und ist durch einen Pfeil 92 veranschaulicht.

## Patentansprüche

1. Wärmetauscherelement, insbesondere für Wärmetauscher zur staubfreien Kühlung von Schaltschränken oder dergl., mit einer Anzahl in einem aus im wesentlichen plattenförmigen Einzelteilen zusammengesetzten blockförmigen Paket nebeneinander angeordneter erster und zweiter Kanäle, die durch wärmetauschende Trennwände voneinander getrennt sind und jeweils auf verschiedenen Paketseiten liegende Ein- und Auslaßöffnungen für durchströmendes wärmezu- und wärmeabführendes Medium aufweisen, dadurch gekennzeichnet, daß zwischen zwei die Ober- und die Unterseite des Paketes bildenden, eingeformte, durchgehende nuten- oder wellenförmige Vertiefungen (3) aufweisenden flachen Profilen (1,2) aufrechtstehende, die Trennwände bildende Lamellen (4, 4a, 40) angeordnet sind, die randseitig in zugeordnete Vertiefungen (3) der beiden flachen Profile (1,2) dicht eingefügt und in diesen gehaltert sind und daß wenigstens eines der flachen Profile (1,2) Ein- und/oder Auslaßöffnungen (8 - 10) der ersten oder der zweiten Kanäle (5,6) bildende Durchbrechungen aufweist, deren zugeordnete Kanäle an wenigstens einer Stirnseite durch aufgesetzte Verschlußelemente (13,14; 30) verschlossen sind.

2. Wärmetauscherelement nach Anspruch 1, dadurch gekennzeichnet, daß die flachen Profile (1,2) gewalzte oder gepreßte Blechprofile sind.

3. Wärmetauscherelement nach Anspruch 1, dadurch gekennzeichnet, daß die flachen Profile (1,2) Strangpreßprofile sind.

4. Wärmetauscherelement nach einem der vorhergehenden Ansprüche, dadurch gekennzeichnet, daß auf die Lamellen (4) stirnseitig jeweils ebenfalls ein eingeformte, durchgehende nuten- oder wellenförmige Vertiefungen (3) aufweisendes flaches Profil (13,14) aufgesteckt ist, in dessen Vertiefungen (3) die Lamellen (4) eingreifen.

5. Wärmetauscherelement nach Anspruch 4, dadurch gekennzeichnet, daß zumindest eines der stirnseitig angeordneten flachen Profile (13, 14) Ein- und/oder Auslaßöffnungen (7,9) der ersten oder der zweiten Kanäle (5,6) bildende Durchbrechungen aufweist.

6. Wärmetauscherelement nach einem der vorhergehenden Ansprüche, dadurch gekennzeichnet, daß die Lamellen (4) ebene Platten sind.

7. Wärmetauscherelement nach einem der Ansprüche 1 - 6, dadurch gekennzeichnet, daß die Lamellen (4a) eine ihre Oberfläche vergrößernde Profilierung aufweisen.

8. Wärmetauscherelement nach Anspruch 7, dadurch gekennzeichnet, daß die Lamellen (4a) eine wellenförmige Querschnittsgestalt aufweisen.

9. Wärmetauscherelement nach einem der vorhergehenden Ansprüche, dadurch gekennzeichnet, daß die Lamellen (40) doppelwandig mit zwei im Abstand gegenüberstehenden Wandteilen (41) ausgebildet sind.

10. Wärmetauscherelement nach Anspruch 9, dadurch gekennzeichnet, daß die beiden Wandteile (41) jeder Lamelle (40) unter Ausbildung eines Profilrohres randseitig miteinander verbunden sind.

11. Wärmetauscherelement nach Anspruch 10, dadurch gekennzeichnet, daß die beiden Wandteile (41) durch Walzen miteinander verbunden sind.

12. Wärmetauscherelement nach Anspruch 9, dadurch gekennzeichnet, daß die beiden Wandteile (41) jeder Lamelle (40) in benachbarte Vertiefungen (3) der flachen Profile (1,2) eingefügt sind.

13. Wärmetauscherelement nach Anspruch 10, dadurch gekennzeichnet, daß jedes Profilrohr mit einem Längsbereich in eine entsprechend gestaltete Vertiefung (3) der flachen Profile (1,2) eingefügt ist (Fig.10, 11).

14. Wärmetauscherelement nach einem der Ansprüche 9 - 13, dadurch gekennzeichnet, daß zwischen den Wandteilen (41) jeder Lamelle (40) die Oberfläche vergrößernde Querwände (42) angeordnet sind, die mit den Wandteilen (41) wärmeleitend verbunden sind.

15. Wärmetauscherelement nach einem der vorhergehenden Ansprüche, dadurch gekennzeichnet, daß die Lamellen (4, 4a, 40) zwischen den Seitenwänden (16) der nutenartigen Vertiefungen (3) seitlich verklemmt sind.

16. Wärmetauscherelement nach Anspruch 15, dadurch gekennzeichnet, daß die Lamellen (4, 4a, 40) unter Zwischenlage von Dichtmaterial (17) verklemmt sind.

17. Wärmetauscherelement nach einem der vorhergehenden Ansprüche, dadurch gekennzeichnet, daß die Verschluß elemente zwischen zwei benachbarte Lamellen (4) oder die Wandungsteile (41) einer doppelwandigen Lamelle (4) stirnseitig eingesteckte Stopfen (30) sind.

18. Wärmetauscherelement nach Anspruch 17, dadurch gekennzeichnet, daß die Stopfen (30) Einlaß- oder Auslaßöffnungen (10) begrenzende Mediumleiteinrichtungen (33) tragen.

19. Wärmetauscherelement nach einem der vorhergehenden Ansprüche, dadurch gekennzeichnet, daß gegenüberliegende flache Profile (1,2; 13,14) durch Zuganker (20, 21; 36) gegeneinander verspannt sind.

20. Wärmetauscherelement nach einem der vorhergehenden Ansprüche, dadurch gekennzeichnet, daß die Lamellen (4, 4a, 40) mit den flachen Profilen (1,2; 13,14) verklebt sind.

21. Wärmetauscherelement nach Anspruch 10, dadurch gekennzeichnet, daß die Profilrohre von einem flüssigen Kühlmedium durchströmt sind.

22. Wärmetauscherelement nach einem der vorhergehenden Ansprüche, dadurch gekennzeichnet, daß die flachen Profile (1,2; 13,14) und/oder die Lamellen (4, 4a,40) aus Kunststoff bestehen.

**Claims**

1. Heat exchanger element, in particular for heat exchangers for the dust-free cooling of switch cabinets or the like, with a number of first and second channels arranged alongside one another in a block-shaped pack essentially composed of plate-shaped components, the said channels being separated from one another by heat-exchanging partitions and having, on different sides of the pack in each case, inlet and outlet openings for a flow medium for the supply and removal of heat, characterised in that, between two flat profiles (1, 2) forming the top side and the underside of the pack and having moulded, continuous groove- or wave-shaped recesses (3), upright laminae (4, 4a, 40) forming the partition walls are arranged, which laminae are tightly inserted edgewise into associated recesses (3) of the two flat profiles and fixed in the latter, and in that at least one of the flat profiles (1, 2) has apertures forming inlet and/or outlet openings (8 - 10) of the first or the second channels (5, 6), the associated channels being closed at least at one front side by the attachment of closing elements (13, 14; 30).

2. Heat exchanger element according to Claim 1, characterised in that the flat profiles (1, 2) are rolled or pressed metal profiles.

3. Heat exchanger element according to Claim 1, characterised in that the flat profiles (1, 2) are extrusion profiles.

4. Heat exchanger element according to any one of the preceding Claims, characterised in that a flat profile (13, 14) having moulded, continuous groove- or wave-shaped recesses (3) is attached to the laminae (4) at the front side, whereby the laminae (4) engage into the said recesses (3).

5. Heat exchanger element according to Claim 4, characterised in that at least one of the flat profiles (13, 14) arranged on the front side has apertures forming inlet and/or outlet openings (7, 9 of the first or the second channels (5, 6).

6. Heat exchanger element according to any one of the preceding Claims, characterised in that the laminae (4) are flat plates.

7. Heat exchanger element according to any one of Claims 1 - 6, characterised in that the laminae (4a) have a profile increasing their surface area.

8. Heat exchanger element according to Claim 7, characterised in that the laminae (4a) have a wave-shaped cross-section.

9. Heat exchanger element according to any one of the preceding Claims, characterised in that the laminae (40) are designed double-walled with two wall parts (41) situated opposite one another and at a distance from one another.

10. Heat exchanger element according to Claim 9, characterised in that the two wall parts (41) of each lamina (40) are connected with one another edgewise thereby forming a profile pipe.

11. Heat exchanger element according to Claim 10, characterised in that the two wall parts (41) are connected with one another by means of crimping.

12. Heat exchanger element according to Claim 9, characterised in that the two wall parts (41) of each lamina (40) are inserted into adjoining recesses (3) of the flat profiles (1, 2).

13. Heat exchanger element according to Claim 10, characterised in that each profile pipe is inserted with a longitudinal section into a correspondingly formed recess (3) of the flat profile (1, 2) (Fig. 10, 11).

14. Heat exchanger element according to any one of Claims 9 - 13, characterised in that transverse walls (42) increasing the surface area are arranged between the wall parts (41) of each lamina (40), said transverse walls being connected with the wall parts (41) in a heat-conducting manner.

15. Heat exchanger element according to any one of the preceding Claims, characterised in that the laminae (4, 4a, 40) are clamped laterally between the side walls (16) of the groove-like recesses (3).

16. Heat exchanger element according to Claim 15, characterised in that the laminae (4, 4a, 40) are clamped having a sealing material (17) interposed between them.

17. Heat exchanger element according to any one of the preceding Claims, characterised in that the closing elements are two stoppers (30) inserted on the front side between two adjoining laminae (4) or the wall parts (41) of a double-walled lamina (4).

18. Heat exchanger element according to Claim 17, characterised in that the stoppers (30) have medium guiding means (33) bordering the inlet and outlet openings (10).

19. Heat exchanger element according to any one of the preceding Claims, characterised in that the flat profiles (1,2; 13, 14) lying opposite one another are braced with regard to one another by means of tie-bars (20, 21; 36).

20. Heat exchanger element according to any one of the preceding Claims, characterised in that the laminae (4, 4a, 40) are stuck to the flat profiles (1,2; 13, 14).

21. Heat exchanger element according to Claim 10, characterised in that the profile pipes have a liquid cooling medium flowing through them.

22. Heat exchanger element according to any one of the preceding Claims, characterised in that the flat profiles (1,2; 13, 14) and/or the laminae (4, 4a, 40) are made of plastic.

**Revendications**

1. Elément échangeur de chaleur, en particulier pour des échangeurs de chaleur pour le refroidissement sans poussière d'armoires de commande ou analogues comportant un certain nombre de premiers et de deuxièmes conduits qui sont disposés côte à côte dans un paquet formant bloc composé d'éléments isolés en forme de plaques, qui sont séparés les uns des autres par des cloisons participant à l'échange de chaleur et qui présentent, sur des côtés différents du paquet, des orifices d'entrée et des orifices de sortie pour l'agent apportant la chaleur et pour l'agent évacuant la chaleur disposés, caractérisé en ce qu'entre deux profilés plats (1, 2) qui sont munis de cavités (3) continues en forme de gorges ou d'ondes et qui constituent la face supérieure et la face inférieure du paquet, sont disposées des lamelles (4, 4a, 40) qui constituent les cloisons et qui, au niveau du bord, sont montées avec étanchéité dans les cavités (3) correspondantes des deux profilés plats (1, 2) et sont maintenues dans celles-ci et en ce que l'un au moins des profilés plats (1, 2) présente des passages qui forment les orifices d'entrée et/ou de sortie (8-10) des premiers ou des deuxièmes conduits (5,6) dont les conduits associés sont obturés sur au moins une face frontale par des éléments d'obturation (13, 14, 30) rapportés.

2. Elément échangeur de chaleur selon la revendication 1, caractérisé en ce que les profilés plats (1, 2) sont des profilés laminés ou estampés en tôle.

3. Elément échangeur de chaleur selon la revendication 1, caractérisé en ce que les profilés plats (1, 2) sont des profilés extrudés.

4. Elément échangeur de chaleur selon l'une des revendications précédentes, caractérisé en ce qu'un profilé plat (13, 14) est monté chaque fois sur la face frontale des lamelles (4), lequel profilé présente également des cavités (3) continues en forme de gorge ou d'onde dans lesquelles s'engagent les lamelles (4).

5. Elément échangeur de chaleur selon la revendication 4, caractérisé en ce que l'un au moins des profilés plats (13, 14) disposés sur les faces frontales présente des passages qui constituent des orifices d'entrée et/ou de sortie (7, 9) des premiers ou des deuxièmes conduits (5, 6).

6. Elément échangeur de chaleur selon l'une des revendications précédentes, caractérisé en ce que les lamelles (4) sont des plaques planes.

7. Elément échangeur de chaleur selon l'une des revendications 1 à 6, caractérisé en ce que les lamelles (4a) présentent un profilage qui augmente leur surface.

8. Elément échangeur de chaleur selon la revendication 7, caractérisé en ce que les lamelles (4a) ont une section en forme d'onde.

9. Elément échangeur de chaleur selon l'une des revendications précédentes, caractérisé en ce que les lamelles (40) ont une paroi double avec des éléments de paroi (41) disposés face à face à distance l'un de l'autre.

10. Elément échangeur de chaleur selon la revendication 9, caractérisé en ce que les deux éléments de paroi (41) de chaque lamelle (40) sont reliés entre eux au niveau du bord pour former un tube profilé.

11. Elément échangeur de chaleur selon la revendication 10 caractérisé en ce que les deux éléments de paroi (41) sont reliés entre eux par laminage.

12. Elément échangeur de chaleur selon la revendication 9, caractérisé en ce que les deux éléments de paroi (41) de chaque lamelle (40) sont montés dans des cavités (3) voisines des profilés plats (1, 2).

13. Elément échangeur de chaleur selon la revendication 10, caractérisé en ce que chaque tube profilé est monté par une partie longitudinale dans une cavité (3) de forme adaptée des profilés plats (1, 2) (figure 10, 11).

14. Elément échangeur de chaleur selon l'une des revendications 9 à 13, caractérisé en ce que entre les éléments de paroi (41) de chaque lamelle (40) sont disposées des cloisons transversales (42) qui augmentent la surface et qui sont reliées aux éléments de paroi (41) sur le plan de la conduction thermique.

15. Elément échangeur de chaleur selon l'une des revendications précédentes, caractérisé en ce que les lamelles (4, 4a, 40) sont coincées latéralement entre les parois latérales (16) des cavités (3) en forme de gorges.

16. Elément échangeur de chaleur selon la revendication 15, caractérisé en ce que les lamelles (4, 4a, 40) sont bloquées avec interposition d'un produit d'étanchéité (17).

17. Elément échangeur de chaleur selon l'une des revendications précédentes, caractérisé en ce que les éléments d'obturation sont des bouchons (30) qui sont enfilés côté frontal entre deux lamelles voisines (4) ou sur les éléments de paroi (41) d'une lamelle à double paroi (4).

18. Elément échangeur de chaleur selon la revendication 17 caractérisé en ce que les bouchons (30) comportent des dispositifs de guidage de l'agent (33) qui définissent des orifices d'entrée ou de sortie (10).

19. Elément échangeur de chaleur selon l'une des revendications précédentes, caractérisé en ce que des profilés plats situés vis-à-vis (1, 2; 13, 14) sont pressés l'un vers l'autre au moyen de tirants (20, 21; 36).

20. Elément échangeur de chaleur selon l'une des revendications précédentes, caractérisé en ce que les lamelles (4, 4a, 40) sont collées sur les profilés plats (1,2; 13, 14).

21. Elément échangeur de chaleur selon la revendication 10, caractérisé en ce que les tubes profilés sont parcourus par un agent de refroidissement liquide.

22. Elément échangeur de chaleur selon l'une des revendications précédentes, caractérisé en ce que les profilés plats (1, 2; 13, 14) et/ou les lamelles (4, 4a, 40) sont en matière plastique.

Fig.1

11

Fig. 2

Fig. 3

Fig.6

Fig.5

Fig.4

Fig. 9

Fig. 8

Fig. 7

Fig. 10

EP 0 234 550 B1

Fig. 12

Fig. 11

Fig. 14

Fig. 13

Fig. 15

EP 0 234 550 B1

Fig. 16

Fig. 17  Fig. 18  Fig. 19  Fig. 20  Fig. 21

Fig.22